# EUROPEAN PATENT APPLICATION

(11) **EP 4 832 734 A1**
(43) Date of publication of application: **28.10.2026**
(21) Application number: 25172402.7
(22) Date of filing: 24.04.2025
(51) Int. Cl.: H10P 72/70

(54) **METHOD OF LIGHT-INDUCED TRANSFER OF A COMPONENT FROM A DONOR SUBSTRATE TO AN ACCEPTOR SUBSTRATE USING A LIGHT BEAM EMITTED BY A LIGHT SOURCE**

(71) Applicant: Nederlandse Organisatie voor toegepast- natuurwetenschappelijk onderzoek TNO, 2595 DA 's-Gravenhage (NL)
(72) Inventor: OLLEARO, Ricardo, 2595 DA 's-Gravenhage (NL); GELINCK, Gerwin Hermanus, 2595 DA 's-Gravenhage (NL); KARKI, Akchheta, 2595 DA 's-Gravenhage (NL); ROSO CASARES, Sergio, 2595 DA 's-Gravenhage (NL); ARUTIVOV, Gari, 2595 DA 's-Gravenhage (NL)
(74) Representative: V.O.

(57) **Abstract**

The present document relates to a method of light-induced transfer of a component from a donor substrate to an acceptor substrate using a light beam emitted by a light source, wherein the donor substrate comprises an optically transparent carrier for transmitting the light beam, and a release structure on the optically transparent carrier, the release structure being configured for attaching the component to the donor substrate and for releasing the component to the acceptor substrate when the release structure is exposed to optical energy from the light beam. The method comprises illuminating, using the light beam, the release structure through the optically transparent carrier and receiving, on the acceptor substrate, the component from the donor substrate. The step of illuminating the release structure is performed, such as to form a hinge from the release structure at an edge of the component, wherein the hinge locally maintains the attachment of the component to the donor substrate with a first bonding strength, such as to cause a rotational motion of the component about the hinge from the donor substrate into angled contact with the acceptor substrate. The component is received on the acceptor substrate with a second bonding strength greater than the first bonding strength. The method further comprises moving the donor substrate and the acceptor substrate with respect to each other, such as to release the attachment of the component to the donor substrate at the hinge.

## Description

### Field of the invention

The present invention is directed at a method of light-induced transfer of a component from a donor substrate to an acceptor substrate using a light beam emitted by a light source. The donor substrate comprises an optically transparent carrier for transmitting the light beam and a release structure on the optically transparent carrier, the release structure being configured for attaching the component to the donor substrate and for releasing the component to the acceptor substrate when the release structure is exposed to optical energy from the light beam. The method comprises illuminating, using the light beam, the release structure through the optically transparent carrier and receiving, on the acceptor substrate, the component from the donor substrate.

### Background

Innovation in the semiconductor industry continues to drive miniaturization of components. At the same time, increasing demands require not only smaller components but also higher throughput in production and assembly.

Some known methods of light-induced component transfer involve the components being placed onto acceptor substrates face-on. While effective, this approach limits design flexibility, particularly in photonic systems, and imposes constraints on how far semiconductor devices can be miniaturized and optimized.

Components may alternatively be placed edge-on, such that components are disposed vertically or at an angle relative to the substrate. This offers significant design advantages for applications such as micro-optic benches, vertical edge-emitting lasers, and quantum photonic circuits. Typically, edge-on placement is achieved through micromanipulation, which involves precise mechanical positioning of individual components. However, micromanipulation is inherently slow, labor-intensive, and difficult to scale, making it unsuitable for high-throughput manufacturing.

### Summary of the invention

It is an object of the present invention to provide a method of component transfer that overcomes the abovementioned drawbacks, and in particular to provide a method of component transfer at high throughputs which allows a high degree of flexibility in component orientation.

To this end, there is provided herewith a method of light-induced transfer of a component from a donor substrate to an acceptor substrate using a light beam emitted by a light source, wherein the donor substrate comprises an optically transparent carrier for transmitting the light beam, and a release structure on the optically transparent carrier, the release structure being configured for attaching the component to the donor substrate and for releasing the component to the acceptor substrate when the release structure is exposed to optical energy from the light beam, wherein the method comprises illuminating, using the light beam, the release structure with the component attached thereto through the optically transparent carrier and receiving, on the acceptor substrate, the component from the donor substrate, wherein the step of illuminating the release structure causes a partial release of the component from the donor substrate, the partial release being such as to form a hinge from the release structure remotely from a center of the component, wherein the hinge locally maintains the attachment of the component to the donor substrate with a first bonding strength, such as to cause a rotational motion of the component about the hinge from the donor substrate into angled contact with the acceptor substrate, wherein the component is received on the acceptor substrate with a second bonding strength greater than the first bonding strength; wherein the method further comprises moving the donor substrate and the acceptor substrate with respect to each other, such as to release the attachment of the component to the donor substrate at the hinge.

The present invention proposes to induce a partial release of components attached to the donor substrate. This allows a released portion of the component to move from the donor substrate onto the acceptor substrate. The released portion of the component can then engage with the acceptor substrate, while the other parts of the component remain attached to the donor substrate. In known methods of light-induced component transfer from donor substrates to acceptor substrates, it is typically the side of the component facing the acceptor substrate while the component is still attached to the donor substrate, that is placed onto the acceptor substrate. But the partial release of the component induced in the method according to the present invention causes the component to shift its orientation with respect to the acceptor substrate, before it is released onto said acceptor substrate and before the attachment of the component to the donor substrate is fully broken. The invention therefore greatly increases flexibility in the placement of the components, because components no longer have to be placed onto acceptor substrates with the sides directly facing the acceptor substrate. The invention in particular forms a hinge remotely from the center, or at an edge of the component through the partial release thereof, which enables a rotational motion of the component. The hinge facilitates a free end portion of the component at an opposite edge with respect to the hinge to move away from the donor substrate and to engage with the acceptor substrate, while the component is still attached to the donor substrate at the hinge. In other words, the partial release of the component enables edge-on placement of components. After transfer and after release from the hinge, the component may be supported by the acceptor structure in a predetermined orientation, for example the component may be placed on its side or on a different surface. The hinge may be formed in many ways. For example, the light beam may be shaped to have an asymmetrical intensity distribution, or the light source may be positioned at an offset with respect to the center of the contact area between the release structure and the donor substrate. Alternatively, the contact area between the component and the release structure may intentionally be misaligned with the center of the component. Other or further ways of forming the hinge in embodiments of the invention may involve providing the donor substrate with a structure at the edge of the component for locally blocking the light beam. The properties of the release structure, such as its thickness or the materials it comprises, may also be varied for enabling a hinge to be formed. Illumination of the release structure causes rapid formation of the hinge, and consequently can cause the rotational motion to initiate automatically, such that the component makes contact with the acceptor substrate. The invention thus provides a method of releasing components edge-on onto acceptor substrates at significantly higher throughputs than micromanipulation. Once the component makes contact with the acceptor substrate, it is still attached to the donor substrate at the hinge, but it is also attached to the acceptor substrate, which is greater than the first bonding strength. At this point in other words, the attachment of the component to the donor substrate has yet to be fully broken. The donor substrate and acceptor substrate at this point therefore have to move with respect to each other in order to release the attachment of the component to the donor substrate at the hinge. The second bonding strength with which the component is attached to the acceptor substrate is therefore greater than the first bonding strength with which the component is attached to the donor substrate, such as to ensure that the attachment of the component to the acceptor substrate is maintained while moving of the donor substrate and the acceptor substrate with respect to each other. Before the attachment of the component to the donor substrate is completely broken, the method according to the invention allows for precise controlling of the orientation of the component through slight movements of the donor substrate or the acceptor substrate. The method therefore is capable of placing components at an angle with a high degree of precision. The method may be applied to many light-induced transfer techniques; the release structures may utilize various processes to facilitate the attachment and release of the components to and from the donor substrate. For example, the optical energy may generate heat in the release structure and subsequently initiate a process of de-wetting that causes a loss of adhesion between the component and the donor substrate. Alternatively, the release structure may contain photoresists including for example photoacid generators or photobase generators. The optical energy from the light beam would then catalyze a chemical reaction changing the solubility of the materials in the release structures in order to facilitate the release of the components to the acceptor substrate. The method according to the first aspect of the invention is therefore highly versatile.

In accordance with some embodiments of the invention, for receiving the component on the acceptor substrate with the second bonding strength, the method further comprises providing the acceptor substrate with an adhesive layer for yielding the second bonding strength. An adhesive is a reliable and easily controllable means of yielding a specific, predetermined second bonding strength at the acceptor substrate. Adhesives may be manufactured to create strong and consistent bonds with minimal variability, which provides the method according to these embodiments with an additional degree of precision in the process of light-induced component transfer. An adhesive layer can in other words be specifically tailored, depending on the materials of the component and the acceptor substrate, to exhibit a predetermined bonding strength in order to adhere the component firmly to the acceptor substrate, while still allowing for precising orienting of the component prior to the attachment of the component to the donor substrate being fully broken. Furthermore, the adhesive layer may be applied with a high degree of uniformity in its thickness, such that the method according to these embodiments gain an additional degree of reliability. Moreover, achieving the second bonding strength using an adhesive layer circumvents the need for complex mechanical or thermal bonding techniques, and thus simplifies the method and avoids potential damage to delicate components during the transfer process.

In accordance with some embodiments of the invention, prior to the step of illuminating, the method comprises providing the component with a projecting structure on a side thereof, such as to form, from the projecting structure, a sidewall structure on the component transferred to the acceptor substrate. The projecting structure may for example be a ridge or protrusion extending transversely from the component. It may for example point toward the optically transparent carrier, or to the acceptor substrate. In this way, the projecting structure, which may also be seen as a feature on the component, may point at least partially or substantially laterally along the acceptor substrate after the component has been received thereon. This provides an advantageous means of providing components with sidewall structures. This is because the sidewall structures may in these embodiments be added to the component prior to the component being placed onto the acceptor substrate, rather than creating such sidewall structures after component placement, via e.g. etching.

In accordance with some embodiments of the invention, for forming the hinge, the method comprises directing or controlling the light beam, such as to achieve a partial illumination of the release structure for providing said partial release by the release structure of the component from the donor substrate. This may typically be done by bringing the optical power of the light beam where the hinge is to be formed down to a level where that portion of the release structure is insufficiently affected by the optical energy of the light beam to induce a release of the component. The attachment of the component to the donor substrate which is provided by the release structure may be locally weakened in this manner. This is an advantageously simple way of forming the hinge. However, in other embodiments this may for example involve misaligning the light source with the release structure, such that the region where the hinge is to be formed is not illuminated.

In accordance with some embodiments of the invention, prior to the step of illuminating, the method comprises defining a region of the release structure for forming of the hinge, and wherein based on the defined region, the method comprises selectively etching a fraction of the release structure. In these embodiments the hinge may be formed prior to the illumination part of the transfer process using etching techniques as known in the art. By forming the hinge in this early stage of the method, a large degree of control may be gained over the rotational movement of the component upon illumination. Since the hinge in these embodiments is already formed prior to illuminating the release structure, its properties, such as geometrical properties, may be analyzed prior to the step of illumination. In this way, the donor substrate may also be optimally positioned prior to illumination, in order to optimize placement of the component onto the acceptor substrate.

In accordance with some embodiments of the invention, the release structure is formed by a stack of layers comprising: an absorption layer for absorbing optical energy from the light beam, the absorption layer having a first melting temperature; a melting layer for being melted by heat from the absorption layer, the melting layer having a second melting temperature below the first melting temperature; and an adhesive layer for adhering the component to the melting layer, and for releasing the adhesion when the melting layer is in a molten state. The adhesive layer of the release structure in these embodiments typically is composed of polymeric materials, which give the layer a high bonding strength to components. This makes the composition of the release structure according to these embodiments highly suitable for being applied in the invention. The light beam propagates through the optically transparent carrier, and may then be incident on the absorption layer of the release structure. In the absorption layer, the optical energy of the light beam may then be absorbed, such that the absorption layer generates heat therein. The heat in the absorption layer then melts the melting layer of the release structure and brings it into a molten, liquid state. The melting temperature of the absorption layer may be higher than the melting temperature of the melting layer, such that the absorption layer can remain solid while the melting layer is melted. Once the melting layer is in a molten state, release of the component, which may adhere to the release structure via the adhesion layer, may occur via a process of de-wetting. The surface energy of the absorption layer may be higher than the surface tension of the molten melting layer. At the same time, the surface tension of the molten melting layer may be higher than the surface energy of the adhesion layer. Therefore, when the melting layer of the release structures is molten, adhesion between the absorption layers and melting layers may be maintained, but adhesion between the melting layers and the adhesion layers may be lost, resulting in the release of the component.

In accordance with some embodiments of the invention, prior to illuminating the release structure, the method comprises controlling, based on a dimension of the component, a distance between the donor substrate and the acceptor substrate for receiving the component on the acceptor substrate at a predetermined angle. When the release structure is illuminated and forms a hinge, the component rotates about this hinge as it detaches from the donor substrate. The arc length of this rotation (and consequently the final contact angle between the component and the acceptor substrate) depends on the distance between the donor and acceptor substrates - on the spacing between them. A smaller distance between the substrates results in a more shallow contact angle, whereas a larger distance allows for a steeper angle, including for example a right angle. By precisely adjusting this distance prior to illuminating the release structure based on the dimensions of the component, it may be ensured that the component engages the acceptor substrate at an optimal angle to achieve secure bonding and correct alignment. This is especially advantageous for components with specific orientation or surface contact requirements, such as optical elements, where misalignment can impair functionality. These embodiments in other words offer significant benefits in terms of precision and process control. Precisely controlling the distance between the substrates allows to predictably control the angular alignment of each transferred component and to reduce variability in placement. Furthermore, the ability to pre-set and adjust this distance provides flexibility for transferring components of varying dimensions without requiring substantial modifications to the overall system setup. These embodiments therefore simplify fine adjustments between transfers of individual components or groups of components during high-throughput manufacturing while maintaining a high degree of accuracy and reproducibility.

In accordance with some embodiments of the invention, for releasing the attachment of the component to the donor substrate at the hinge, the method comprises determining, based on the first bonding strength and on the second bonding strength, a force to be induced on the component by the moving of the donor substrate and the acceptor substrate with respect to each other, such as to release the attachment of the component to the donor substrate at the hinge and for maintaining the angled contact of the component with the acceptor substrate. Prior to the step of moving the donor substrate and the acceptor substrate with respect to each other, the component is attached at two points: one side remains connected to the donor substrate via the hinge with the first bonding strength, while the other side is already bonded to the acceptor substrate with the second bonding strength, which is larger than the first bonding strength. Determining the force to be induced on the component during the relative movement of the donor and acceptor substrates allows to ensure that the component detaches cleanly from the hinge while maintaining secure attachment to the acceptor substrate. The movement in these embodiments advantageously may exert a force precisely calibrated in both magnitude and direction to overcome the first bonding strength at the hinge without disrupting the stronger attachment to the acceptor substrate. If the force is too weak, the hinge might not release, leaving the component partially attached to the donor substrate. Conversely, if the force is too strong or misdirected, it could damage the component, disrupt its positioning, or even break the second bond at the acceptor substrate. Pre-determining the magnitude and direction of this force on the other hand is advantageous because it allows for a controlled and predictable release process, minimizing the risk of errors or damage. By considering both bonding strengths and the specific mechanical properties of the component and substrates, these embodiments enable fine-tuning of the force to ensure optimal detachment dynamics. Additionally, factors such as the material properties of the component or hinge elasticity may be taken into account during this force calibration.

In accordance with some embodiments of the invention, prior to illuminating the release structure, a center of the contact area between the component and the release structure is positioned at an offset from the center of the component. In these embodiments, when the release structure is illuminated through the optically transparent carrier, the optical energy may be absorbed unevenly due to the misalignment between the center of the contact area between the component and the release structure and the center of the component. This asymmetry may cause localized weakening or breakdown of the release structure in regions of the release structure removed from the offset, resulting in the formation of a hinge at the region of the offset. Positioning the center of the contact area between the component and the release structure at an offset from the center of the component thus provides an effective way to form the hinge during the light-induced release process. These embodiments provide a relatively easy to achieve means of forming the hinge because it relies on geometric and spatial alignment rather than requiring additional processing steps or complex modifications to the release structure itself.

In accordance with some embodiments of the invention, prior to illuminating the release structure, the method comprises optically aligning the donor substrate with the light source, such that for the forming of the hinge, a center of an intensity distribution of the light beam from the light source is positioned at an offset from a center of a contact area between the component and the release structure. Positioning the center of the intensity distribution of the light beam at an offset from the center of the contact area between the component and the release structure offers a precise and elegant method for forming the hinge during the light-induced release process. In these embodiments, the optical energy delivered by the light beam is not centrally distributed across the contact area but is instead concentrated asymmetrically at a specific region. This targeted illumination causes localized heating or structural weakening in the release structure, creating the hinge at the region receiving the least optical energy. The offset may thus ensure that the hinge forms predictably in a predefined region, serving as a controlled pivot point for the rotational motion of the component following local detachment. These embodiments avoid the need for complex mechanical interventions or additional structural modifications, relying instead on precise optical alignment. The hinge formation in these embodiments occurs through localized absorption of optical energy at the offset region, weakening the release structure in a controlled manner while leaving the rest of the attachment largely intact. As the optical alignment may be controlled with high precision, the hinge's position can be consistently reproduced across multiple transfer events, ensuring predictable detachment behavior. Furthermore, these embodiments are highly compatible with automated and high-throughput manufacturing systems, as optical alignment can be performed with precision using advanced imaging and positioning systems.

In accordance with some embodiments of the invention, the method comprises controlling a beam shape of the light beam from the light source, such as to yield an asymmetrical beam shape for illuminating a portion of the release structure removed from the edge of the component for the forming of the hinge. Controlling the beam shape of the light beam to produce an asymmetrical illumination pattern on a portion of the release structure provides an elegant and highly controllable method for forming the hinge. Advantageously, the hinge may be formed in these embodiments at least in part through optical manipulations, rather than by physical modifications to the donor substrate or release structure. Beam shaping can for example be done using optical elements such as masks, diffractive optical elements (DOEs), or spatial light modulators (SLMs), allowing precise control over the spatial energy distribution of the light beam. The asymmetrical beam shape may direct optical energy to a portion of the release structure, causing localized release of the attachment of the component to the donor substrate. This results in the formation of a hinge at a specific area. The asymmetrical beam shape can be dynamically adjusted using programmable optical elements, allowing real-time optimization for example for different component geometries or material properties.

In accordance with some embodiments of the invention, the asymmetrical shape is one of a group comprising: elliptical shapes, semi-elliptical shapes, semi-circular shapes, crescent shapes, trapezoidal shapes, rectangular shapes.

In accordance with some embodiments of the invention, for forming of the hinge, the donor substrate is provided with a structure at the edge of the component for locally blocking the light beam from the light source. These embodiments fix the critical parameters of the transfer mechanism directly into the physical design of the donor substrate, ensuring that the hinge will consistently form at the desired location without requiring dynamic optical adjustments during the step of illumination. The blocking structure effectively prevents light from reaching specific regions of the release structure, thereby creating a controlled zone where attachment of the component to the donor substrate is not weakened during the step of illumination. As a result, the hinge may be reliably established at the edge of the component.

In accordance with some embodiments of the invention, the release structure is one of a plurality of release structures attaching the component to the donor substrate, the plurality of release structures being spatially distributed on the optically transparent carrier, wherein for forming of the hinge, at least one of: the plurality of release structures are concentrated near the edge of the component; and respective thicknesses of release structures near the edge of the component are sufficiently large for locally maintaining the attachment of the component to the donor substrate with the first bonding strength, and respective thicknesses of release structures removed from the edge of the component are sufficiently small for releasing the attachment of the component to the donor substrate. In these embodiments, the optical energy required for detaching the component is effectively minimized. Since the total contact area between the release structures and the component is spatially limited to a smaller area than in embodiments where a release structure covers the entire component, less optical energy is needed to weaken or break the attachment of the component to the release structures. Embodiments where the release structures are concentrated near the edge of the component also provide an advantageous means of inducing the detachment in a controlled manner, with the hinge forming consistently along the edge where the structures are most densely distributed. Furthermore, in embodiments where the thickness of the release structures is varied - thicker near the edge and thinner away from it - the release structures near the edge inherently exhibit greater mechanical stability and bonding strength, allowing them to maintain attachment under controlled stress during the transfer process. In contrast, the thinner release structures located away from the edge are more susceptible to optical energy-induced weakening, facilitating detachment in those regions first. This thickness gradient effectively creates a natural pivot point at the thicker structures near the edge, enabling predictable rotational motion of the component. Additionally, although in these embodiments the hinge is still formed, the attachment of the component to the donor substrate at the hinge may still be weakened through the reception of optical energy from the light beam. This helps facilitate the eventual release of said attachment at the hinge during the step of moving the donor substrate and the acceptor substrate with respect to each other.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figures 1A-1C schematically illustrate a setup of the transfer process at three moments in an embodiment of the method according to the invention.
Figure 2 schematically illustrates embodiments of the method in accordance with the invention.
Figures 3A-3C schematically illustrate various methods of forming the hinge, in accordance with some embodiments of the invention.
Figures 4A-4C schematically illustrate various implementations of the release structure of the donor substrate, in accordance with some embodiments of the invention.

### Detailed description

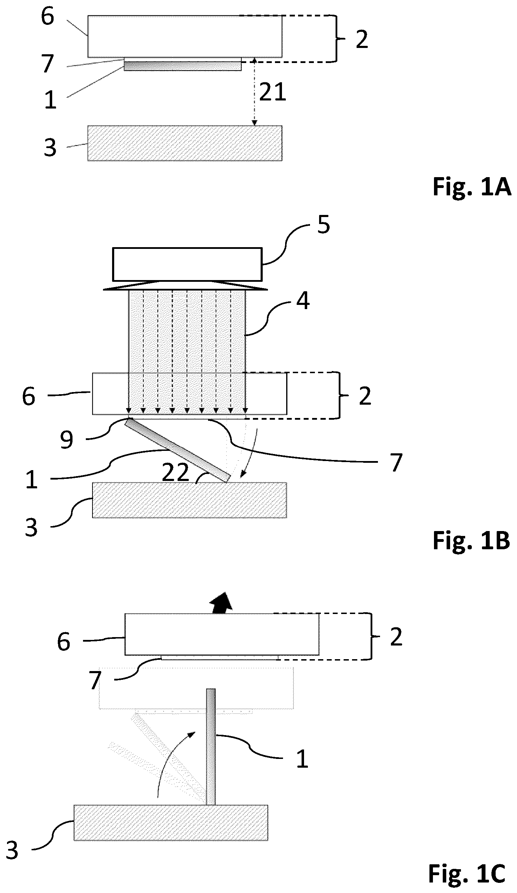

Figure 1A schematically illustrates a component 1 attached to a donor substrate 2, and an acceptor substrate 3. The donor substrate 2 comprises an optically transparent carrier 6 and a release structure 7. The optically transparent carrier 6 during the method according to the invention receives the light beam 4 from the light source 5, as shown in figure 1B, and transmits it to the release structure 7. The release structure 7 is configured for attaching the component 1 to the donor substrate 2 until it receives optical energy from the light beam 4, at which point the release structure 7 releases said attachment. In the method according to the invention, rather than releasing the attachment of the component 1 to the donor substrate 2 across its entire footprint, the component 1 is instead only partially released, and a hinge 9 is formed at the edge of the component 1. The formation of this hinge 9 causes a rotational motion of component 1 about the hinge 9, onto the acceptor substrate 3. Consequently, the component 1 is not received on the acceptor substrate face-on, but rather the acceptor substrate 3 engages with the component 1 in angled contact at an angle 22, while the component 1 is also simultaneously still attached to the donor substrate 2 at the hinge 9. Angle 22 depends on the distance 21 between the donor substrate 2 and the acceptor substrate 3 and on the size of the component 1. The method thus enables components to be brought into contact with an acceptor substrate 3 edge-on, rather than face-on with the side of component 1 that faces the acceptor substrate 3 while the component 1 is still attached to the donor substrate 2. At this point in the method, the attachment of the component 1 to the donor substrate 2 has yet to be fully broken. In order to release the component 1 from the hinge 9, the method involves moving the donor substrate and the acceptor substrate with respect to each other, as shown in figure 1C. In this figure, the donor substrate 2 is moved upwards, away from the acceptor substrate 3 in order to complete the release of the component 1 from the release structure 7. The direction and magnitude of acceleration of the donor substrate 2, a force is induced at the hinge 9. In order for this force to break the attachment of the component 1 to the donor substrate 2, while maintaining the attachment of the component 1 to the acceptor substrate 3, the component 1 is held onto the acceptor substrate 3 with a bonding strength that is greater than the bonding strength holding the component 1 to the donor substrate 2 at the hinge 9. The force caused by the movement of the donor substrate 2 away from the acceptor substrate not only causes the bond between the component 1 and the release structure 7 to be broken, but can also cause a further rotation of the component 1 into a desired orientation. In this figure, the component 1 is brought into an upright position. In alternative embodiments, rather than the donor substrate 2 being moved away from the acceptor substrate 3, the acceptor substrate 3 may instead be moved away from the donor substrate 2, or both substrates may be moved for this purpose.

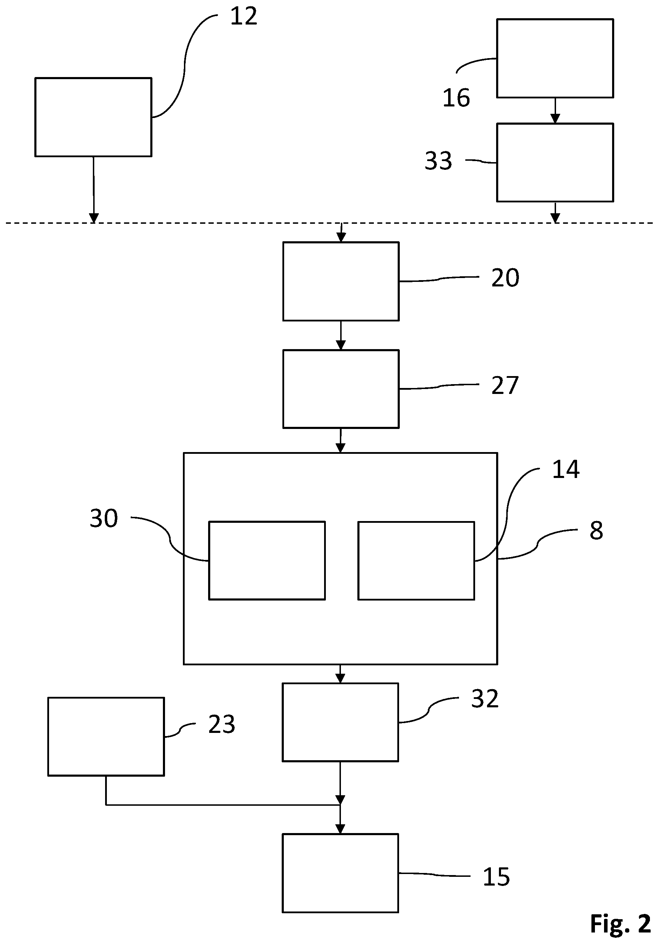

Figure 2 schematically illustrates steps that may be executed during the method in accordance with embodiments of the invention. For example, the method may involve a step 12 of providing the acceptor substrate 3 with an adhesive layer. Such an adhesive layer is an advantageous means of yielding the bonding strength with which the component 1 will be bound to the acceptor substrate 3. In some embodiments, the formation of the hinge 9 may already be aided or prepared before the step 8 of illumination. This may be done by first defining 16 a region of the release structure where the hinge is to be formed, or alternatively where the release structure is to be released during the step 8 of illumination. Next, based on this defined region, the method may involve a step 33 of partial under-etching in order to remove a portion of the release structure where the component 1 is to be released during the step 8 of illumination. By partially removing or weakening the release structure 7 locally in this way, the hinge 9 may be formed more easily, significantly increasing the consistency of the method. Since the angle 22 with which the component 1 is received on the acceptor substrate 3 depends on the distance 21 between the donor substrate 2 and the acceptor substrate 3, and on the dimension of the component 1 along the direction from the hinge 9 to the rotating free end portion of the component 1, the method may further comprise a step 20 of controlling the distance 21 between the two substrates. In this way, the angle 22 may be determined beforehand. This may be advantageous e.g. in cases where the component 1 does not rotate further upon movement 15 of the two substrates with respect to each other. The hinge 9 of the release structure may be formed in various ways. The method may for example further involve optically aligning 27 the donor substrate with the light source 5 in such a way as to create an offset between the center of the intensity distribution of the light beam 4 and the center of the contact area between the component 1 and the release structure 7. In this way, the release structure 7 may be made to let go of the component away from one edge of the component, which is furthest away from the center of the intensity distribution of the light beam 4. Additionally or alternatively, the hinge 9 may be formed during the step 8 of illuminating the release structure 7. For example, during illumination of the release structure 7, the beam shape of the light beam 4 may be controlled 30 in order to obtain an asymmetric beam shape. A similar effect may be achieved in this way as in embodiments where there is an offset between the center of the intensity distribution and the center of the contact area between the component 1 and the release structure 7: the edge of the component 1 where the hinge 9 is to be formed may in these cases receive no or receive insufficient optical energy from the light beam for the local attachment of the component 1 to the release structure 7 to be released there. Since this attachment is maintained during the illumination 8 locally, the hinge 9 may be thusly formed. Furthermore, the method may involve during illumination 8 a step 14 of controlling the optical power of the light beam 4 such that it is sufficiently high to partially release the component 1 from the release structure 7, but sufficiently low for this light-induced release to happen only partially. The optical power of the light beam 4 in these embodiments may especially be brought sufficiently low such that the amount of optical energy received at the edge of the component 1 where the hinge 9 is to be formed is insufficient for causing the release. Once the hinge 9 is formed and the component 1 rotates about the hinge 9 toward the acceptor substrate, the method next involves receiving 32 of the component 1 onto the acceptor substrate with a bonding strength greater than the bonding strength with which the component is still attached to the donor substrate 2 via the hinge 9. At this point in the method, the attachment of the component 1 to the donor substrate is to be fully released, but it is important that the attachment of the component 1 to the acceptor substrate 3 is maintained. The method may therefore involve determining 23 the force to be induced at the hinge by movement 15 of the donor substrate and the acceptor substrate 3 with respect to each other. Precise control over the final orientation of the component 1 may in this way be advantageously attained.

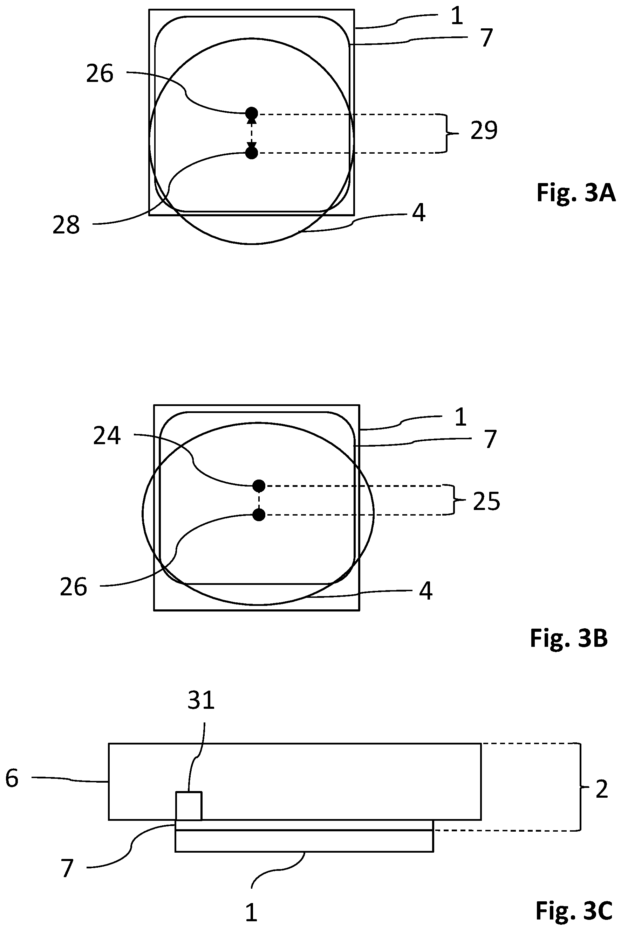

Figures 3A-3C schematically illustrate various ways in which the hinge 9 may be advantageously formed in the method. For example, in figure 3A the light beam 4 used to illuminate the release structure 7 has an intensity distribution with a center 28 that is at an offset 29 from the center 26 of the contact area between the component 1 and the release structure 7. This offset 29 is an advantageous way to make sure that the attachment between the component 1 and the donor substrate 2 is partially released - i.e., locally released apart from the edge of the component 1 where the hinge 9 is to be formed. In this case the hinge 9 will be formed at the edge away from the direction in which the offset 29 is formed. In alternative embodiments, such as the one shown in figure 3B, the hinge 9 may be formed by attaching the component 1 to the donor substrate 2 with a release structure 7 the center 24 of which is already at an offset 25 from the center 26 of the component 1. As an optional additional measure taken to form the hinge 9, the beam shape in this embodiment is controlled to have an asymmetrical shape that aids in making sure the edge of the component 1 where the hinge 9 is to be formed receives insufficient optical energy from the light beam to induce the release of the component 1 from the release structure 7 at that edge. In figure 3C, an embodiment is shown of a donor substrate 2 where a structure 31 or feature is added in the donor substrate 2. The structure or feature 31 serves to locally block light from the light beam 4. This is another advantageous means of ensuring that the hinge 9 is formed in the step of illumination 8.

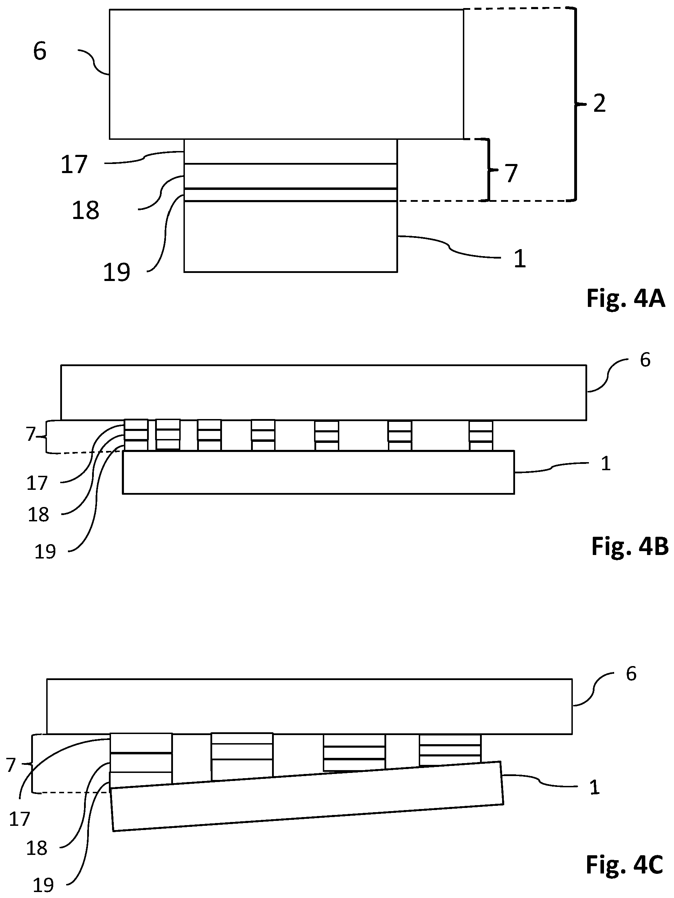

Figure 4A schematically illustrates a component 1 attached to a donor substrate 2 in accordance with an embodiment of the invention. In this embodiment, the release structure 7 comprises a stack of layers. The stack includes an absorption layer 17, which receives optical energy from the light beam 4 through the optically transparent carrier 6 and consequently generates heat therein. The heat in these embodiments consequently melts the melting layer 18 and brings it into a molten, liquid state. The melting temperature of the absorption layer 17 may in these embodiments be higher than the melting temperature of the melting layer 18, such that the absorption layer 17 can remain solid while the melting layer 18 is melted. Once the melting layer is in a molten state, release of the component 1, which may adhere to the release structure via the adhesion layer 19, may in these embodiments occur via a process of de-wetting. The surface energy of the absorption layer 17 may be higher than the surface tension of the molten melting layer 18. At the same time, the surface tension of the molten melting layer 18 may be higher than the surface energy of the adhesion layer 19. Therefore, when the melting layer 18 is molten, adhesion between the absorption layer 17 and melting layer 18 may be maintained, but adhesion between the melting layer 18 and the adhesion layer 19 may be lost, resulting in the release of the component 1. This release may then be made partial in accordance with the invention in various ways, such that a hinge is formed at an edge of the component 1, as has been discussed above. Some additional embodiments, in which formation of the hinge is prepared or aided, are shown in figures 4B and 4C. In figure 4B, a plurality of release structures 7 are spatially distributed across the footprint of the component 1 on the optically transparent carrier 6. The use of spatially distributed, small release structures 7 that each only cover a portion of the component 7 advantageously reduces the required amount of optical energy to release the component 1 from the donor substrate 2. In order to aid in the formation of the hinge, the release structures 7 in this figure are more concentrated near the edge of the component 1 where the hinge is to be formed. Figure 4C shows an alternative embodiment, where release structures are uniformly concentrated across the component, but are thicker near the edge where the hinge is to be formed, while they are thinner in this embodiment where the component 1 is to be partially released upon illumination.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Any of the claimed or disclosed devices or portions thereof may be combined together or separated into further portions unless specifically stated otherwise, without departing from the claimed invention. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

## Claims

1. Method of light-induced transfer of a component from a donor substrate to an acceptor substrate using a light beam emitted by a light source, wherein the donor substrate comprises an optically transparent carrier for transmitting the light beam, and a release structure on the optically transparent carrier, the release structure being configured for attaching the component to the donor substrate and for releasing the component to the acceptor substrate when the release structure is exposed to optical energy from the light beam,
wherein the method comprises illuminating, using the light beam, the release structure with the component attached thereto through the optically transparent carrier and receiving, on the acceptor substrate, the component from the donor substrate,
wherein the step of illuminating the release structure causes a partial release of the component from the donor substrate, the partial release being such as to form a hinge from the release structure remotely from a center of the component, wherein the hinge locally maintains the attachment of the component to the donor substrate with a first bonding strength, such as to cause a rotational motion of the component about the hinge from the donor substrate into angled contact with the acceptor substrate,
wherein the component is received on the acceptor substrate with a second bonding strength greater than the first bonding strength;
wherein the method further comprises moving the donor substrate and the acceptor substrate with respect to each other, such as to release the attachment of the component to the donor substrate at the hinge.

2. Method according to claim 1, wherein for receiving the component on the acceptor substrate with the second bonding strength, the method further comprises providing the acceptor substrate with an adhesive layer for yielding the second bonding strength.

3. Method according to claim 1 or 2, wherein prior to the step of illuminating, the method comprises providing the component with a projecting structure on a side thereof, such as to form, by the projecting structure after transfer of the component, a sidewall structure on the component supported by the acceptor substrate.

4. Method according to any of the preceding claims, wherein for forming the hinge, the method comprises directing or controlling the light beam, such as to achieve a partial illumination of the release structure for providing said partial release by the release structure of the component from the donor substrate.

5. Method according to any of the preceding claims, wherein prior to the step of illuminating, the method comprises defining a region of the release structure for forming of the hinge, and wherein based on the defined region, the method comprises selectively under-etching a fraction of the release structure.

6. Method according to any of the preceding claims, wherein the release structure is formed by a stack of layers comprising:
- an absorption layer for absorbing optical energy from the light beam, the absorption layer having a first melting temperature;
- a melting layer for being melted by heat from the absorption layer, the melting layer having a second melting temperature below the first melting temperature; and
- an adhesive layer for adhering the component to the melting layer, and for releasing the adhesion when the melting layer is in a molten state.

7. Method according to any of the preceding claims, wherein prior to illuminating the release structure, the method comprises controlling, based on a dimension of the component, a distance between the donor substrate and the acceptor substrate for receiving the component on the acceptor substrate at a predetermined angle.

8. Method according to any of the preceding claims, wherein for releasing the attachment of the component to the donor substrate at the hinge, the method comprises determining, based on the first bonding strength and on the second bonding strength, a force to be induced on the component by the moving of the donor substrate and the acceptor substrate with respect to each other, such as to release the attachment of the component to the donor substrate at the hinge and for maintaining the angled contact of the component with the acceptor substrate.

9. Method according to any of the claims 4-8, wherein prior to illuminating the release structure, a center of the contact area between the component and the release structure is positioned at an offset from the center of the component.

10. Method according to any of the claims 4-9, wherein prior to illuminating the release structure, the method comprises optically aligning the donor substrate with the light source, such that for the forming of the hinge, a center of an intensity distribution of the light beam from the light source is positioned at an offset from a center of a contact area between the component and the release structure.

11. Method according to any of the claims 4-10, wherein the method comprises controlling a beam shape of the light beam from the light source, such as to yield an asymmetrical beam shape for illuminating a portion of the release structure removed from the edge of the component for the forming of the hinge.

12. Method according to claim 11, wherein the asymmetrical shape is one of a group comprising: elliptical shapes, semi-elliptical shapes, semi-circular shapes, crescent shapes, trapezoidal shapes, rectangular shapes.

13. Method according to any of the preceding claims, wherein for forming of the hinge, the donor substrate is provided with a structure at the edge of the component for locally blocking the light beam from the light source.

14. Method according to any of the preceding claims, wherein the release structure is one of a plurality of release structures attaching the component to the donor substrate, the plurality of release structures being spatially distributed on the optically transparent carrier, wherein for forming of the hinge, at least one of:
- the plurality of release structures are concentrated near the edge of the component; and
- respective thicknesses of release structures near the edge of the component are sufficiently large for locally maintaining the attachment of the component to the donor substrate with the first bonding strength, and respective thicknesses of release structures removed from the edge of the component are sufficiently small for releasing the attachment of the component to the donor substrate.
